# EUROPEAN PATENT APPLICATION

(11) **EP 0 838 862 A1**
(43) Date of publication of application: **29.04.1998**
(21) Application number: 97116806.7
(22) Date of filing: 26.09.1997
(51) Int. Cl.: H01L 29/417, H01L 29/08, H01L 21/336

(54) **Semiconductor device and method of producing the same**

(30) Priority: 27.09.1996 JP 256917/96
(71) Applicant: NEC CORPORATION, Tokyo (JP)
(72) Inventor: Abiko, Hitoshi, Minato-ku, Tokyo (JP); Sakai, Isami, Minato-ku, Tokyo (JP)
(74) Representative: Betten, Jürgen, Dipl.-Ing.

(57) **Abstract**

A semiconductor device with trench isolation of the present invention includes silicide layers covering the side walls portions of a device region exposed in contact holes. Diffusion layers are formed, and each includes a portion self-aligning with one of the silicide layers. A method of producing such a semiconductor device includes the steps of forming the contact holes, depositing metal having a high melting point, forming silicide, and then forming self-aligning diffusion layers by diffusing an impurity from the silicide.

## Description

### BACKGROUND OF THE INVENTION

The present invention relates to a semiconductor device promoting dense and highly integrated packaging and a method of producing the same and, more particularly, to the structure of contact portions of a MOSFET (Metal Oxide Semiconductor Field Effect Transistor) with trench isolation and a method of producing the same.

A semiconductor device with an isolation region formed by trenches is conventional. The trenches are formed in the surface of a semiconductor substrate and then filled with silicon oxide. After a gate electrode and diffusion layers have been formed, the entire surface of the resulting laminate is covered with an interlayer insulation film. Contact holes are formed in the insulation film. A metal film is formed in the contact holes and then patterned to form wirings. The problem with this semiconductor device is that a junction leak current characteristic deteriorates due to the progress of microstructure which is derived from the high integration of semiconductor devices. Specifically, because the dimensions of the semiconductor device, as seen in a plan view, are reduced due to the progress of microconfiguration, a margin for the positional deviation between the contact holes and the diffusion layers is reduced. As a result, the contact holes are apt to partly extend to the outside of the diffusion layers. It follows that a metal film for wiring filled in the contact holes short-circuits the substrate and diffusion layers, aggravating the junction leak current problem.

Japanese Patent Laid-Open Publication No. 62-190847 proposes a solution to the above problem. Specifically, in this document, a silicon nitride film intervenes between a silicon oxide film filling an isolation region and a substrate. This kind of scheme, however, brings about another problem that a difference between the coefficient of thermal expansion of the substrate and that of the silicon nitride film is noticeable and introduces defects in the substrate during heating due to a thermal stress. The defects also aggravates the junction leak.

Japanese Patent Laid-Open Publication No. 60-128662 proposes another solution to the problem discussed above. The solution consists in filling contact holes with polycrystal silicon and causing an impurity to be diffused from the silicon. The problem with this scheme is that the diffusion of an impurity from the polycrystal silicon is not achievable without resorting to a temperature of 900° or above. Such a high temperature varies the impurity distributions of various diffusion layers and others constituting the semiconductor device.

### SUMMARY OF THE INVENTION

It is therefore an object of the present invention to provide a semiconductor device with an extended contact hole structure and capable of obviating an increase in junction leakage current ascribable to a microstructure, and a method of producing the same.

A semiconductor device of the present invention includes a silicon substrate. A device region is delimited by an isolation region formed by forming trenches in the silicon substrate and then filling the trenches with an insulating material. An interlayer insulating film is formed on the silicon substrate formed with the isolation region. Contact holes extend throughout the interlayer insulation film such that the side walls of the device region are partly exposed in the contact holes. Diffusion layers are formed in the device region, and each consists of a silicide layer of metal having a high melting point and covering a portion of the device region exposed in the contact hole, and a portion self-aligning with the silicide layer. Wirings each is connected to the silicide layer of one of the diffusion layers.

A method of producing a semiconductor device of the present invention includes a step of forming trenches in the surface of a silicon substrate and then filling the trenches with an insulating material to thereby form an isolation region delimiting a device region. First diffusion layers contacting the isolation region are selectively formed on the surface of the device region. An interlayer insulation film is formed over the entire surface of the silicon substrate, and then contact holes are formed which extend throughout the interlayer insulation film to the first insulation layers such that the side walls of the device region are partly exposed in the contact holes. A film containing metal having a high melting point is formed over the entire surface of the silicon substrate, and the resulting laminate is heated to thereby form silicide layers of the metal in device region portions of the contact holes. Second diffusion layers are formed which respectively self-aligne with the silicide layers and are connected to the first diffusion layers. A conductive film is formed and then patterned to thereby form wirings each consisting of a film containing the above metal and a conductive film in a double layer structure.

### BRIEF DESCRIPTION OF THE DRAWINGS

The above and other objects, features and advantages of the present invention will become apparent from the following detailed description taken with the accompanying drawings in which:
FIGS. 1-3 are sections showing a sequence of steps for producing a conventional semiconductor device;
FIGS. 4 and 5 are sections for describing the problem of the conventional semiconductor device;
FIG. 6 is a section showing another conventional semiconductor device;
FIG. 7 is a section showing still another conventional semiconductor device;
FIGS. 8-19 are sections showing a sequence of steps for producing a semiconductor device embodying the present invention; and
FIGS. 20-22 are sections showing a sequence of steps representative of an alternative embodiment of the present invention.

### DESCRIPTION OF THE PREFERRED EMBODIMENTS

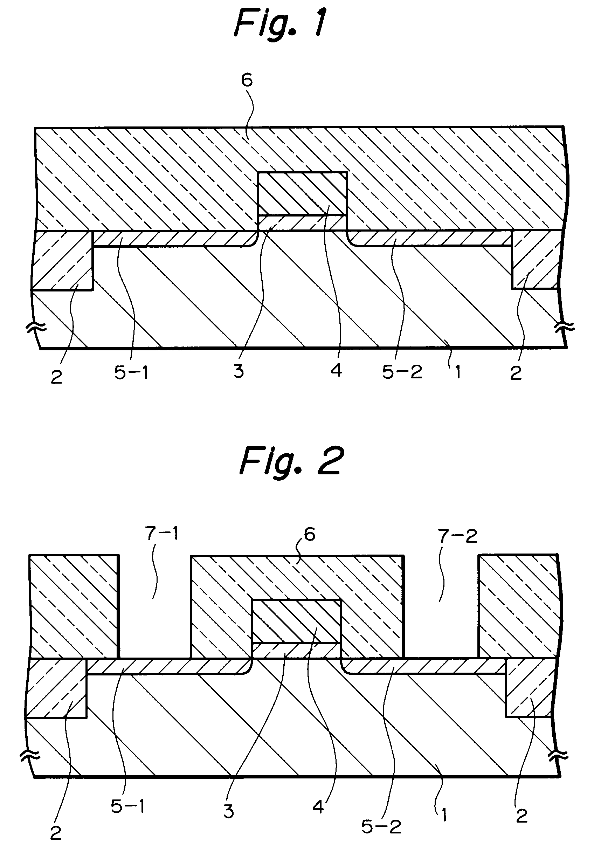

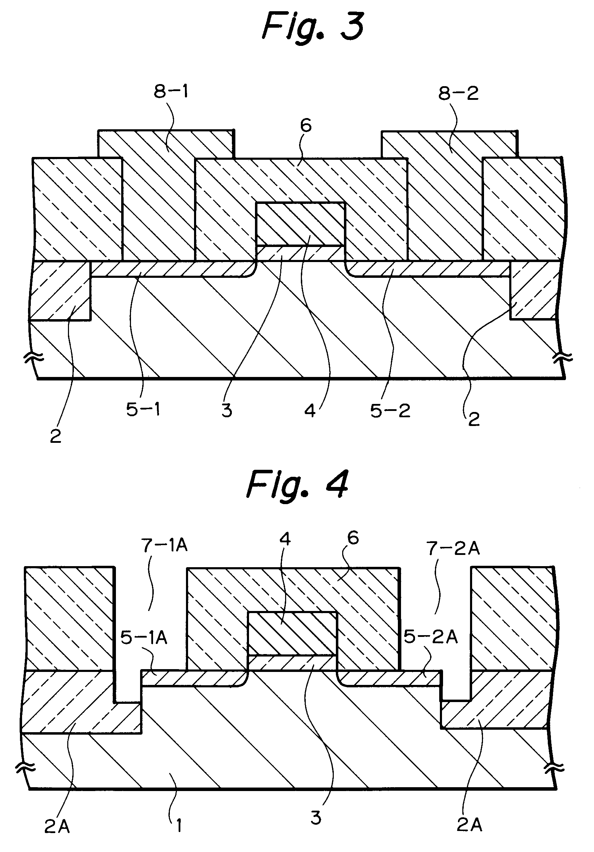

To better understand the present invention, brief reference will be made to a conventional semiconductor device with trench isolation, shown in FIG. 1. As shown, the semiconductor device includes a P type silicone substrate 1 formed with trenches in the surface thereof. Silicon oxide 2 is filled in the trenches of the substrate 1, forming an isolation region. A gate electrode 4 is formed on the substrate 1 with the intermediary of a gate insulation film 3. N⁺ type diffusion layers 5-1 and 5-2 (source and drain) are also formed on the substrate 1. By these steps, a MOSFET is produced. Then, the surface of the laminate is covered with an interlayer insulation film 6. Subsequently, as shown in FIG. 2, contact holes 7-1 and 7-2 are formed in the insulation layer 6. As shown in FIG. 3, a metal film for wiring is formed and then patterned to form wirings 8-1 and 8-2.

However, the problem with the semiconductor device shown in FIG. 1 is that a junction leak current characteristic deteriorates due to the progress of microstructure which is derived from the high integration of semiconductor devices, as stated earlier. Specifically, because the dimensions of the semiconductor device, as seen in a plan view, are reduced due to the progress of microstructure, a margin for the positional deviation between the contact holes 7-1 and 7-2 and the diffusion layers 5-1 and 5-2 in which they are formed is reduced. Therefore, the contact holes 7-1 and 7-2 are apt to partly extend to the outside of the diffusion layers 5-1 and 5-2.

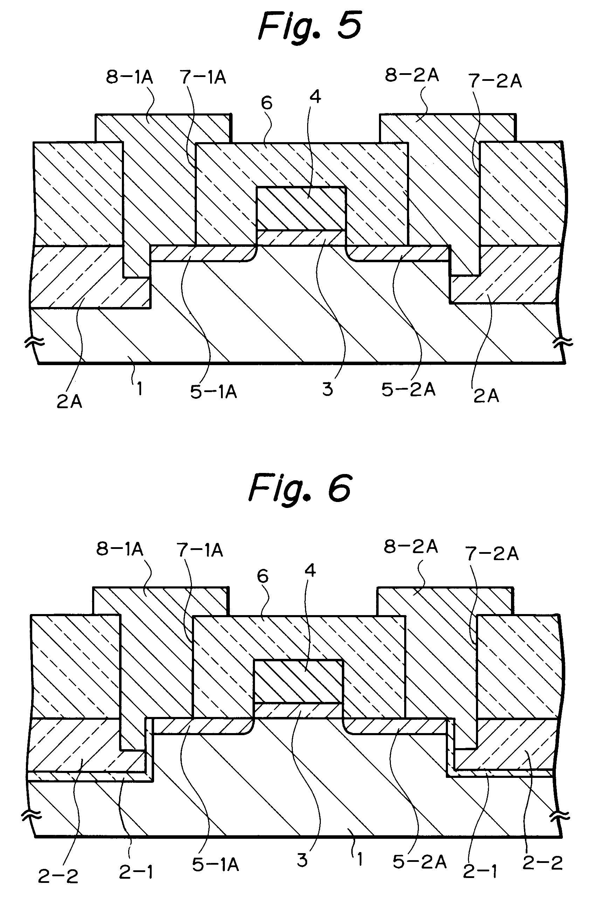

Apart from the accidental positional deviation, the dimensions of the diffusion layers 5-1 and 5-2 may be intentionally reduced such that the contact holes 7-1 and 7-2 partly extend to the outside of the diffusion layers 5-1 and 5-2. FIG. 4 shows this kind of structure, i.e., extended contact hole structure mentioned earlier. As shown, when contact holes 7-1A and 7-2A are formed by anisotropic etching, the bottoms of the holes 7-1A and 7-2A are positioned below the surfaces of diffusion layers 5-1A and 5-2A (source and drain) outside of the diffusion layers 5-1A and 5-2A for the following reason. Generally, the thickness of the interlayer insulation film 6 and the etching rate during fabrication are not constant. In light of this, the laminate shown in FIG. 4 is etched deeply enough to expose the surfaces of the diffusion layers 5-1A and 5-2A at worst. As shown in FIG. 5, when the contact holes 7-1A and 7-2A are filled with a metal film for wiring, wirings 8-1A and 8-2A contact the portions of the substrate 1 adjoining the diffusion layers 5-1A and 5-2A and deeper than the interface between the substrate 1 and the layers 5-1A and 5-2A, resulting in short-circuiting. This aggravates the junction leak current problem. Although such an occurrence is not critical if the junction depth of the diffusion layers 5-1A and 5-2A is sufficiently great, an increase in junction depth obstructs the microconfiguration of the semiconductor device.

FIG. 6 shows a semiconductor device proposed in previously mentioned Japanese Patent Laid-Open Publication No. 62-190847 in order to solve the above problem. As shown, a silicon nitride film 2-1 intervenes between a silicon oxide film 2-2 filling an isolation region and the substrate 1. This kind of scheme, however, brings about another problem that a difference between the coefficient of thermal expansion of the substrate 1 and that of the silicon nitride film 2-1 is noticeable and introduces defects in the substrate 1 during heating due to a thermal stress. The defects also aggravate the junction leak current.

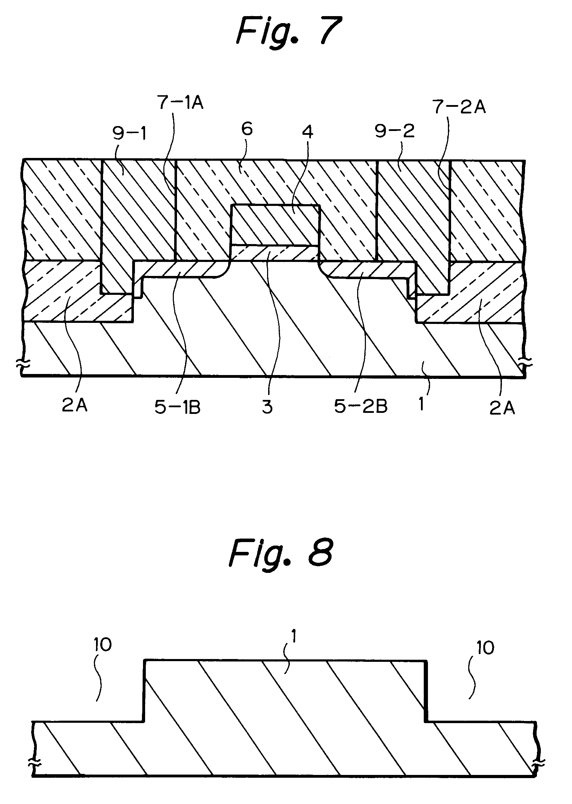

Further, FIG. 7 shows a semiconductor device taught in previously mentioned Japanese Patent Laid-Open Publication No. 60-128662. As shown, the contact holes 7-1A and 7-2A are respectively filled with polycrystal silicon 9-1 and 9-2, so that an impurity is diffused from the silicon 9-1 and 9-2. The problem with this scheme is that the diffusion of an impurity from the polycrystal silicon is not achievable without resorting to a temperature of 900° or above. Such a high temperature varies the impurity distributions of various diffusion layers and others constituting the semiconductor device.

Preferred embodiments of the semiconductor device in accordance with the present invention will be described hereinafter. In the illustrative embodiments, structural elements identical with the elements shown in FIGS. 1-7 are designated by identical references.

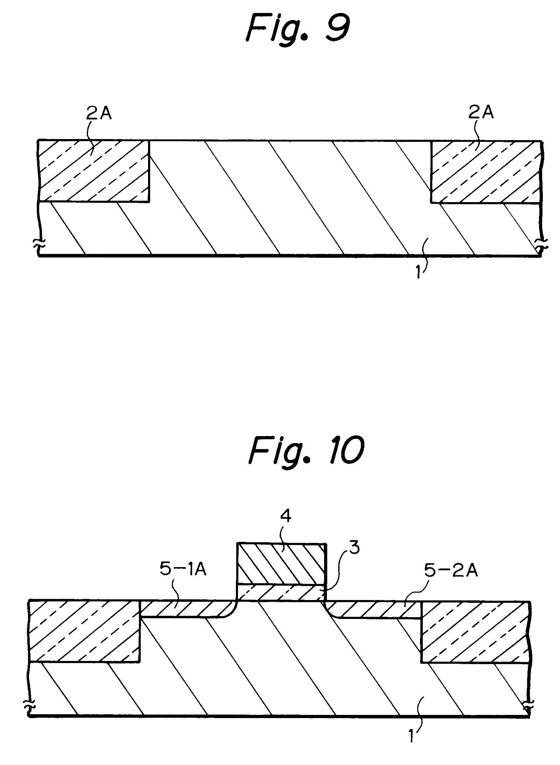

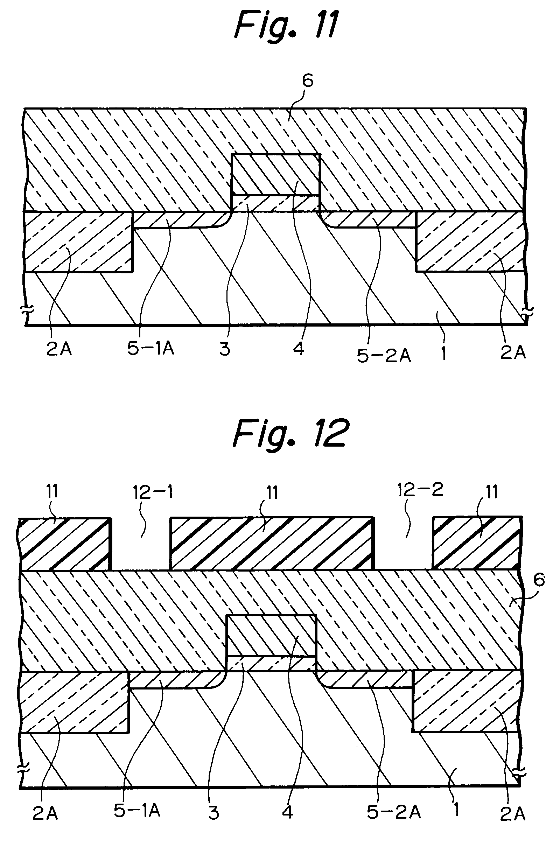

Referring to FIGS. 8-19, a semiconductor device embodying the present invention and a method of producing the same are shown. First, as shown in FIG. 8, trenches 10 are formed in the surface of a P type silicon substrate 1, forming a device region having, e.g., a rectangular shape as seen in a plan view. As shown in FIG. 9, the trenches 10 are filled with, e.g., silicon oxide 2A. As shown in FIG. 10, after a gate insulation film 3 has been formed, a gate electrode 4 and N⁺ type diffusion layers 5-1A and 5-2A (source and drain) are formed. The diffusion layers 5-1A and 5-2A have an impurity concentration of 1 x 10²⁰ cm⁻³ to 1 x 10²¹ cm⁻³ and a junction depth of about 0.1 µm. Then, as shown in FIG. 11, an interlayer insulation film 6 is formed.

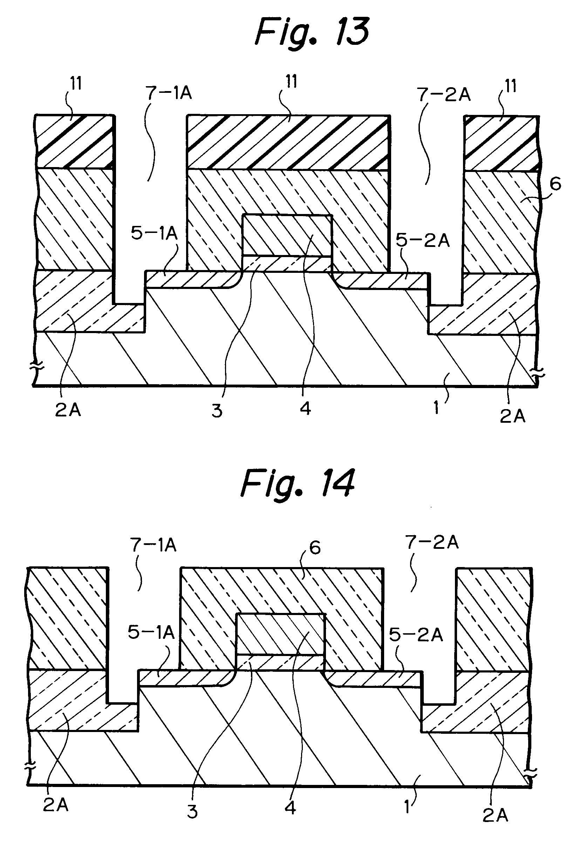

Subsequently, as shown in FIG. 12, contact holes 12-1 and 12-2 are formed in a photoresist film 11 by photolithography. As shown in FIG. 13, contact holes 7-1A and 7-2A are formed in the interlayer insulation film 6 by anisotropic etching with the above photoresist film 11 serving as a mask. The anisotropic etching is implemented as plasma etching using, e.g., CF₄ gas with which a sufficient selection ratio is available with respect to silicon. The contact holes 7-1A and 7-2A each has a diameter of 0.25 µm to 0.5 µm. In the step shown in FIG. 13, the anisotropic etching is continued even after the surfaces of the diffusion layers 5-1A and 5-2A have been exposed for the purpose stated earlier in relation to the structure of FIG. 4. As a result, it may occur that the etching proceeds to a depth of 150 nm to 200 nm as measured from the surface of the silicon oxide 2A.

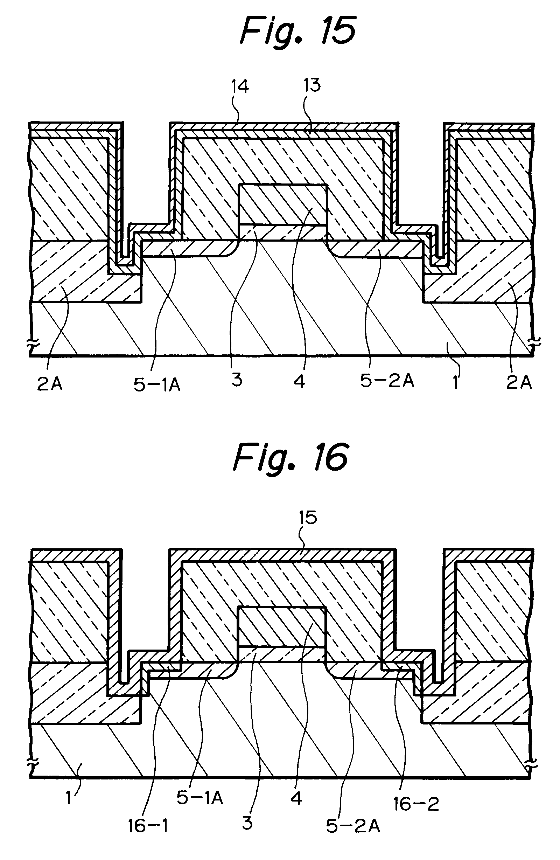

Subsequently, as shown in FIG. 14, the photoresist film 11 is removed. As shown in FIG. 15, a 10 nm titanium film 13 and a 50 nm to 100 nm thick titanium nitride film 14 are sequentially formed on the entire surface of the laminate of FIG. 14

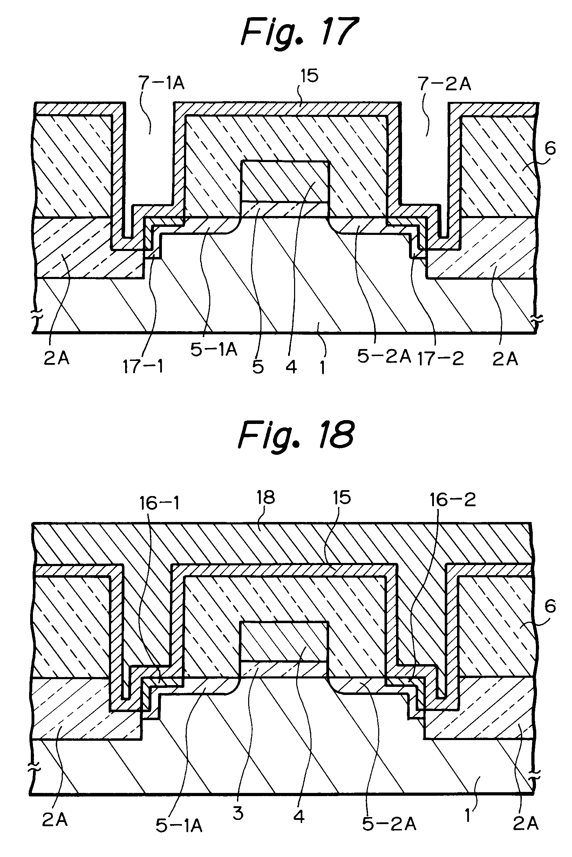

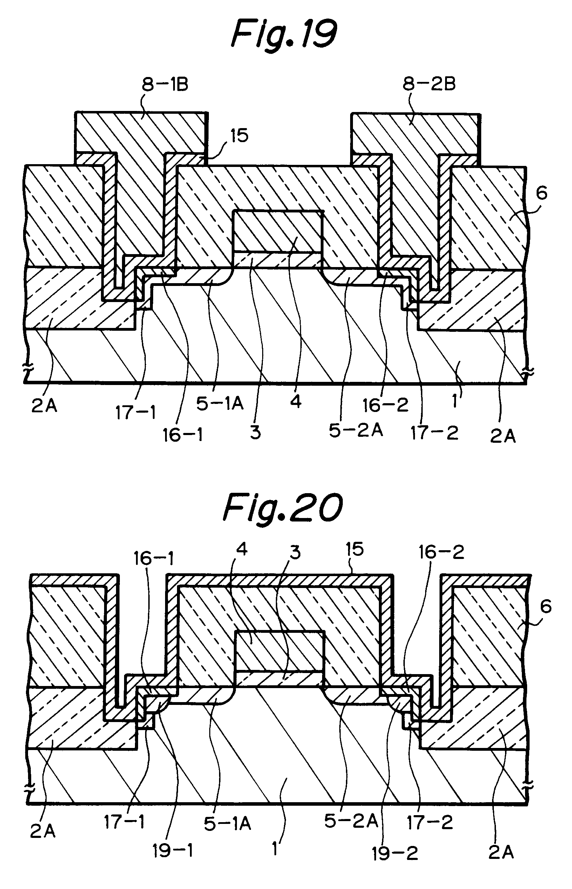

The laminate shown in FIG. 15 is heated for at least 10 seconds at a temperature of 700°C or above, but below 900°C, in a nitrogen or similar atmosphere, e.g., for 1 minute at 800°C. Consequently, as shown in FIG. 16, 20 nm to 30 nm thick titanium silicide (TiSi_{X}; X = 1 to 2) layers 16-1 and 16-2 are formed because the titanium film 13 reacts on the silicon of the substrate 1. At the same time, the portions not contacting the substrate 1 are almost entirely nitrided, forming a titanium nitride (TiN) film 15. At this instant, an N type impurity (arsenic or phosphor) existing in the N⁺ type diffusion layers 5-1A and 5-2A is introduced into the TiSi_{X} layers 16-1 and 16-2 and diffused via the layers 16-1 and 16-2 to the portions contacting the substrate 1. It is to be noted that the diffusion of the N type impurity in the titanium silicide layers 16-1 and 16-2 occurs with a factor greater than a diffusion factor in the substrate 1 by one figure to two figures, depending on the particle size. As a result, as shown in FIG. 17, N type diffusion layers 17-1 and 17-2 are formed while self-aligning with the titanium silicide layers 16-1 and 16-2. The N type diffusion layers 17-1 and 17-2 are respectively connected to the N⁺ type diffusion layers 5-1A and 5-2A. In this condition, the titanium silicide layers 17-1 and 17-2 are prevented from directly contacting the P type portion of the substrate 1. Subsequently, as shown in FIG. 19, wirings 8-1B and 8-2B are formed, completing a semiconductor device or IC (Integrated Circuit).

As stated above, in the illustrative embodiment, trenches are formed in the surface of the P type silicon substrate 1 and then filled with the silicon oxide 2A, forming a device region. The interlayer insulation film 6 is formed on the substate 1 provided with the isolation region. The contact holes 7-1A and 7-2A extend throughout the insulation film 6 while exposing a part of the side walls of the device region. The diffusion layers 5-1A and 5-2A are provided in the device region and respectively have the titanium silicide layers 16-1 and 16-2 and the portions (17-1 and 17-2) self-aligning with the layers 16-1 and 16-2. The wirings 8-1B and 8-2B are respectively connected to the titanium silicide layers 16-1 and 16-2.

The titanium silicide layers 16-1 and 16-2 respectively intervene between the wirings 8-1B and 8-2B and the N⁺ type diffusion layers 5-1A and 5-2A without fail. The wirings 8-1B and 8-2B each consists of an aluminum-silicon-cuprum (Al-Si-Cu) alloy film and a titanium nitride film provided in a double layer structure. This, coupled with the fact that the N⁺ diffusion layers 5-1A and 5-2A respectively intervene between the titanium silicide layers 16-1 and 16-2 and the P type portion of the substrate 1, prevents the wirings 8-1B and 8-2B from directly contacting the P type portion of the substrate 1. Further, the illustrative embodiment reduces the junction leak current because it is free from defects ascribable to a thermal stress. In addition, the embodiment eliminates heating using a temperature of 900°C or above; otherwise, impurity distributions would be varied and would influence the electric characteristic of the semiconductor device.

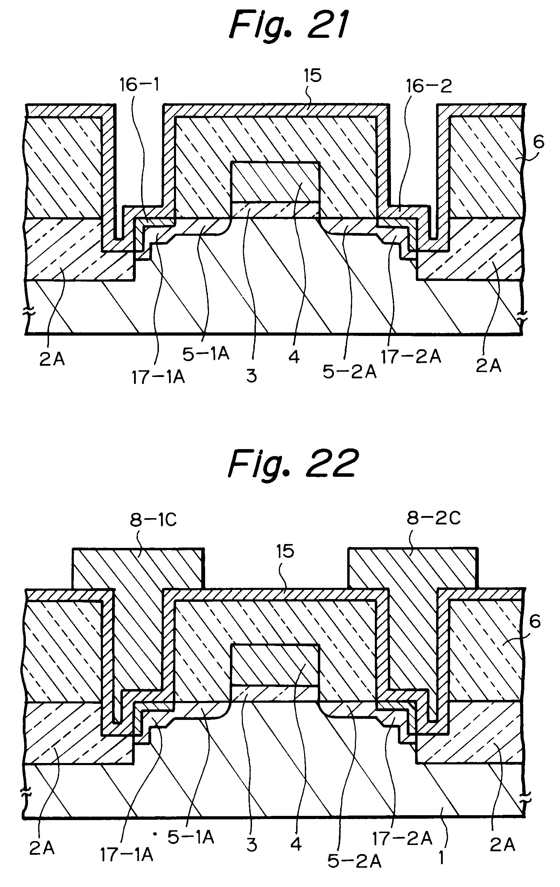

FIGS. 20-22 show an alternative embodiment of the present invention. This embodiment is identical with the previous embodiment up to the step of forming the titanium nitride film 15 and titanium silicide layers 16-1 and 16-2 (FIG. 20). Subsequently, the embodiment forms implantation layers 19-1 and 19-2 by the ion implantation of phosphor or arsenic. Then, the resulting laminate is heated for 30 seconds at 800°C in order to activate the implantation layers 19-1 and 19-2 and to cause the impurity to be diffused from the titanium silicide layers 16-1 and 16-2 into the substrate 1. As a result, as shown in FIG. 21, N type diffusion layers 17-1A and 17-2A are formed and connected to the N⁺ type diffusion layers 5-1A and 5-2A, respectively. This process allows a sufficient amount of impurity to exist between the titanium silicide layers 16-1 and 16-2 and the substrate 1. Finally, as shown in FIG. 22, wiring layers 8-1C and 8-2C are formed to complete an IC, as in the previous embodiment.

With the above alternative embodiment, it is possible to further promote the sure formation of N type diffusion layers self-aligning with titanium silicide layers.

While the implantation layers 19-1 and 19-2 are shown as being formed more deeply than the N⁺ type diffusion layers 5-1A and 5-2A, the implantation may be effected with energy just enough for the impurity to be implanted in the titanium silicide layers 16-1 and 16-2.

Experiments showed that the illustrative embodiments each reduces junction leak current by two figures, compared to the conventional semiconductor device shown in FIG. 6.

Titanium used in the embodiments as metal having a high melting point may be replaced with tungsten (W) or tantalum (Ta) by way of example. The embodiments have concentrated on a titanium nitride film and a titanium film provided in a double layer structure as films containing metal having a high melting point. However, the crux is that such films form silicide layers, preferably those covered with barrier films, at their portions contacting a silicon substrate. For example, use may be made of a TaN film and a Ta film, a TiW film, or a TiN film and a TiW film. The present invention is, of course, applicable to a structure in which contact holes are accidentally extended to an isolation region due to misalignment, as distinguished from a structure in which they are intentionally extended to the isolation region.

In summary, in accordance with the present invention, a semiconductor device includes silicide layers implemented by metal having a high melting point and covering the portions of a device region exposed in contact holes. The silicide layers prevent wirings from directly contacting the portions of a silicon substrate adjoining diffusion layers. This, coupled with the fact that defects ascribable to a thermal stress are obviated, prevents junction leak current from increasing even in the intentionally extended contact hole structure. Stated another way, the area of diffusion layers and therefore junction capacitance is reduced. This contributes a great deal to the microstructure and high speed operation of the semiconductor device.

Various modifications will become possible for those skilled in the art after receiving the teachings of the present disclosure without departing from the scope thereof.

## Claims

1. A semiconductor device comprising:
a silicon substrate;
a device region delimited by an isolation region formed by forming trenches in said silicon substrate and then filling said trenches with an insulating material;
an interlayer insulating film formed on said silicon substrate formed with said isolation region;
contact holes extending throughout said interlayer insulation film such that side walls of said device region are partly exposed in said contact holes;
diffusion layers formed in said device region, and each consisting of a silicide layer of metal having a high melting point and covering a portion of said device region exposed in the contact hole, and a portion self-aligning with said silicide layer; and
wirings each being connected to said silicide layer of one of said diffusion layers.

2. A semiconductor device as claimed in claim 1, further comprising a barrier film provided on a side of each of said wirings connected to an associated one of said silicide layers, said barrier film containing a same element as the metal having a high melting point.

3. A semiconductor device as claimed in claim 2, wherein said silicide layers each comprises a titanium silicide layer while said barrier film comprises a titanium nitride film.

4. A method of producing a semiconductor device, comprising the steps of:
(a) forming trenches in a surface of a silicon substrate and then filling said trenches with an insulating material to thereby form an isolation region delimiting a device region;
(b) selectively forming first diffusion layers contacting said isolation region on a surface of said device region;
(c) forming an interlayer insulation film over an entire surface of said silicon substrate and then forming contact holes extending throughout said interlayer insulation film to said first insulation layers such that side walls of said device region are partly exposed in said contact holes;
(d) forming a film containing metal having a high melting point over the entire surface of said silicon substrate and then heating a resulting laminate to thereby form silicide layers of said metal in device region portions of said contact holes, and forming second diffusion layers respectively self-aligning with said silicide layers and connected to said first diffusion layers; and
(e) forming a conductive film and then patterning said conductive film to thereby form wirings each consisting of a film containing said metal and a conductive film in a double layer structure.

5. A method as claimed in claim 4, further comprising (f) sequentially forming a titanium film and a titanium nitride film in this order to thereby form said film containing said metal.

6. A method as claimed in claim 4, wherein said metal comprises titanium.

7. A method as claimed in claim 6, further comprising (f) sequentially forming a titanium film and a titanium nitride film in this order to thereby form said film containing said metal.

8. A method as claimed in claim 4, wherein an impurity of a same conductivity type as said first diffusion layers is implanted via said silicide layers, and then heating is performed again.

9. A method as claimed in claim 8, wherein said metal comprises titanium.

10. A method as claimed in claim 9, further comprising (f) sequentially forming a titanium film and a titanium nitride film in this order to thereby form said film containing said metal.
